Europäisches Patentamt

(19) European Patent Office

Office européen des brevets

(11) Numéro de publication : **0 276 181 B1**

(12) **FASCICULE DE BREVET EUROPEEN**

(45) Date de publication du fascicule du brevet :
23.10.91 Bulletin 91/43

(51) Int. Cl.$^5$ : **H02H 3/38, G01R 29/16**

(21) Numéro de dépôt : **88400051.4**

(22) Date de dépôt : **11.01.88**

(54) **Procédé et dispositif pour la recherche de conducteurs en défaut dans une ligne électrique.**

(30) Priorité : 22.01.87 FR 8700722

(43) Date de publication de la demande :
27.07.88 Bulletin 88/30

(45) Mention de la délivrance du brevet :
23.10.91 Bulletin 91/43

(84) Etats contractants désignés :
CH DE FR GB LI SE

(56) Documents cités :
EP-A- 0 079 504
FR-A- 1 597 420
FR-A- 2 177 467
US-A- 4 447 845

(73) Titulaire : **SCHLUMBERGER INDUSTRIES**
**50, avenue Jean Jaurès**
**F-92120 Montrouge (FR)**

(72) Inventeur : **Souillard, Michel**
**16, rue des Fauvettes**
**F-92260 Fontenay Aux Roses (FR)**

(74) Mandataire : **Weinmiller, Jürgen et al**
**Lennéstrasse 9 Postfach 24**
**W-8133 Feldafing (DE)**

EP 0 276 181 B1

**Description**

La présente invention concerne un procédé, et son dispositif associé, permettant la recherche, dans le but final d'une identification, d'un ou plusieurs conducteurs en défaut dans un élément de transport d'énergie électrique, comprenant trois conducteurs et trois phases correspondantes, affecté par un défaut dissymétrique.

Le procédé comprend essentiellement les opérations consistant à :

— élaborer, au moins à partir des valeurs prises par un paramètre électrique pour les trois phases, un premier signal relatif à une phase et lié à la composante de ce paramètre électrique dans un système vectoriel équilibré symétrique inverse,

— élaborer, au moins à partir des valeurs prises par ledit paramètre électrique pour les trois phases, un second signal relatif à ladite phase et lié à la composante de ce paramètre électrique dans un système vectoriel équilibré non symétrique inverse (c'est-à-dire homopolaire ou direct),

— soumettre les premier et second signaux à une comparaison de leurs angles de phase, et

— déterminer, en fonction du résultat de cette première comparaison, si ladite phase joue, ou non, un rôle privilégié vis-à-vis du défaut.

Un procédé de ce type est décrit dans le brevet français FR 1597420.

Ce brevet fait référence à l'emploi des systèmes vectoriels équilibrés, bien connus de l'homme de l'art.

La théorie de ces systèmes prévoit notamment qu'un système de trois vecteurs quelconques peut être remplacé par trois systèmes vectoriels équilibrés, dont l'un est dit "symétrique direct", un autre "symétrique inverse" et le troisième "homopolaire".

Chacun des trois systèmes équilibrés est un système à trois vecteurs de modules identiques, ces vecteurs ayant une résultante nulle dans le cas des systèmes symétriques direct et inverse, et une résultante égale à trois fois chacun d'eux dans le cas du système homopolaire.

Le recours à la notion de systèmes vectoriels équilibrés est d'une grande utilité pour l'homme de l'art dans la mesure où ce dernier, de façon traditionnelle, représente tout signal électrique alternatif par un vecteur qui tourne dans un plan complexe avec une fréquence égale à celle du signal électrique et qui présente un module constant égal à la valeur maximale, encore appelée "amplitude", du signal électrique.

Ainsi, bien que le mot "vecteur" appartienne a priori au language mathématique, l'homme de l'art dans le domaine de l'invention l'utilise en référence aux grandeurs concrètes que constituent les signaux électriques.

L'invention concernée apparaît, d'une certaine façon, comme un perfectionnement de l'invention faisant l'objet du brevet français FR 1597420 précédemment mentionné.

Ce brevet décrit un procédé et un dispositif qui permettent, dans le cas de défauts dissymétriques avec conduction à la terre, de déterminer si une phase joue un rôle privilégié par rapport au défaut (ce qui n'est le cas que lorsque cette phase est la seule en défaut ou la seule à ne pas être en défaut) ou si au contraire elle ne joue aucun rôle privilégié (elle est alors en défaut avec une autre phase) ; dans un deuxième temps, le procédé et le dispositif décrits permettent d'identifier chaque phase en défaut.

Ces procédé et dispositif antérieurs permettent en outre, dans le cas de défauts dissymétriques isolés par rapport à la terre, d'identifier la phase qui ne participe pas au défaut, les deux autres phases étant donc affectées par ce dernier.

Le procédé antérieur décrit dans le brevet FR 1597420 repose, comme cela est rappelé dans le préambule ci-dessus, sur une comparaison de phases.

Plus précisément, pour déterminer si, parmi les trois phases a, b, et c de la ligne en défaut, la phase a joue un rôle privilégié, le procédé connu comprend tout d'abord l'élaboration, pour cette phase a, à partir des valeurs d'un paramètre électrique relatif aux trois phases, par exemple à partir des tensions $V_a$, $V_b$ ou $V_c$ ou des courants $I_a$, $I_b$ ou $I_c$ des phases a, b et c, d'un premier signal lié à la composante inverse de ce paramètre pour la phase a, c'est-à-dire de la tension inverse $V_{ia}$ ou du courant inverse $I_{ia}$ de la phase a, puis l'élaboration, à partir des valeurs du même paramètre électrique, d'un second signal lié à la composante homopolaire (cas des défauts à la terre) ou directe (cas des défauts isolés par rapport à la terre) de ce paramètre, c'est-à-dire l'élaboration soit de la tension directe $V_{da}$ ou homopolaire $V_{oa}$ ($=V_{ob}=V_{oc}=V_o$), soit du courant direct $I_{da}$ ou homopolaire $I_{oa}$ ($=I_{ob}=I_{oc}=I_o$) ; enfin le procédé connu comprend une comparaison des angles de phase des premier et second signaux, dont le résultat indique si la phase a joue, ou non, un rôle privilégié vis-à-vis du défaut.

Un procédé basé, de façon similaire, sur une comparaison des angles de phase entre les composantes inverse et homopolaire du courant est aussi connu du brevet EP-A-0079504. Pour permettre la distinction entre un défaut monophasé à la terre et un défaut biphasé des deux autres phases à la terre, la tension entre ces dernières phases est utilisée dans ce procédé comme troisième signal, et la différence entre les angles de phase de ces trois signaux est prise comme critère de discrimination.

Si le succès qu'ont connu le procédé et le dispositif du brevet FR 1597420 suffit à constituer la preuve des avantages considérables qu'ils ont apportés, ils ont récemment révélé certaines limitations, notamment avec la mise en place de nouvelles configurations de réseaux électriques.

En effet, dans certaines configurations de défauts et de réseaux, il arrive que l'une des composantes de tension ou de courant utilisée à l'extremité de la ligne à laquelle on cherche à identifier la ou les phases en défaut, ne soit plus significative à cette extrêmité, c'est-à-dire que l'amplitude de cette composante soit si faible que son angle de phase ne peut pas être connu avec certitude, ce qui rend impossible la détermination des phases en défaut.

C'est le cas, par exemple, sur les lignes dont une extrêmité est raccordée à une source puissante d'énergie électrique, tandis que l'autre extrêmité est raccordée à une source faible.

Pour un défaut monophasé, ou biphasé à la terre, les composantes homopolaires et inverses de tension peuvent ne pas être significatives à une extrêmité de la ligne et les composantes homopolaires et inverses de courant peuvent ne pas être significatives à l'autre extrêmité, rendant inefficace à l'une des extrêmités tout dispositif utilisant des composantes de tension ou de courant.

Dans ce contexte, l'invention a pour but d'apporter une solution simple et efficace au problème précèdemment mentionné.

L'invention, qui repose sur la mise en évidence du fait que les relations d'angles utilisées dans le brevet FR 1597420 ne sont pas modifiées substantiellement lorsqu'une composante de tension ou de courant est remplacée par une composante mixte, et qui comprend, comme indiqué précèdemment, les opérations consistant à élaborer, pour une des phases, des premier et second signaux, et à effectuer une comparaison des phases de ceux-ci, est essentiellement caractérisée en ce que le premier signal est une combinaison linéaire des composantes symétriques inverses de tension et de courant relatives à cette phase, et en ce que le second signal est une combinaison linéaire de composantes de tension et de courant relatives à cette phase dans un système vectoriel équilibré non symétrique inverse (c'est-à-dire homopolaire ou direct).

Dans le cas de défauts à la terre, le second signal est de préférence une combinaison linéaire des composantes homopolaires de tension et de courant de ladite phase.

Dans ce cas, le procédé de l'invention peut en outre comprendre les opérations consistant à :

— élaborer pour ladite phase un troisième signal constitué par une combinaison linéaire des composantes directes de tension et de courant de cette phase,

— soumettre aussi les premier et troisième signaux à une comparaison d'angles de phase, et

— déterminer, en fonction du résultat de cette seconde comparaison, si le défaut affecte un ou deux conducteurs.

Dans le cas de défauts isolés par rapport à la terre, le second signal est de préférence une combinaison linéaire des composantes directes de tension et de courant de la phase en question.

Dans tous les cas, la combinaison linéaire adopte avantageusement la forme V-Z.I, où V est la composante de tension, I la composante de courant et Z une impédance au plus égale à la moitié de l'impédance correspondante de l'élément de transport d'énergie.

Le dispositif de l'invention, qui vise à permettre l'identification, dans un élément de transport d'énergie électrique à trois conducteurs et trois phases correspondantes affecté par un défaut dissymétrique, de la phase qui, vis-à-vis du défaut, joue un rôle privilégié et qui comprend :

— des premier et second moyens pour produire, à partir des valeurs prises par un premier paramètre électrique représentatif des tensions pour les trois phases, des premier et second signaux intermédiaires relatifs à l'une des phases et liés respectivement à la composante de ce paramètre électrique dans un système vectoriel équilibré non symétrique inverse et symétrique inverse,

— un comparateur d'angles de phase, et

— un circuit logique relié à la sortie de ce comparateur, est essentiellement caractérisé en ce qu'il comprend en outre :

— des troisième et quatrième moyens pour produire, à partir des valeurs prises par un second paramètre électrique représentatif des courants pour les trois phases, des troisième et quatrième signaux intermédiaires relatifs à ladite phase et liés respectivement à la composante de ce paramètre électrique dans un système vectoriel équilibré non symétrique inverse et symétrique inverse,

— un premier circuit de combinaison linéaire pour élaborer un premier signal de sortie représentant une combinaison linéaire des premier et troisième signaux intermédiaires, et

— un second circuit de combinaison linéaire pour élaborer un deuxième signal de sortie représentant une combinaison linéaire des second et quatrième signaux intermédiaires, ledit comparateur d'angles de phase recevant les signaux de sortie des premier et second circuits de combinaison linéaire.

D'autres caractéristiques de l'invention ressortiront de la description qui en est faite ci-après, à titre indicatif et nullement limitatif, en référence aux dessins annexés, parmi lesquels :

— la figure 1 est un tableau des déphasages entre les premier et second signaux utilisés dans le cadre de l'invention, en fonction des défauts rencontrés ;

— la figure 2 est un schéma d'un dispositif conforme à l'invention.

L'invention concerne la protection des lignes électriques et plus précisément l'identification de conducteurs en défaut dans une ligne affectée par un défaut dissymétrique.

Les lignes comprennent généralement quatre conducteurs A, B, C, N dont trois transportent l'énergie électrique et dont l'un, N, est à un potentiel neutre.

Traditionnellement, le signal sinusoïdal de puissance électrique transporté par chaque conducteur A, B, C s'appelle "phase" et les trois phases, relatives aux trois conducteurs A, B, C, sont désignées par les lettres minuscules a, b, c.

Par défaut dissymétrique, on entend un défaut d'isolation électrique entre deux phases, avec ou sans connexion à la terre, ou un défaut d'isolation entre une phase et la terre.

La protection d'une ligne électrique est effectuée par des relais disposés aux extrêmités de celle-ci et recevant des signaux $V_a$, $V_b$, $V_c$ représentatifs des tensions des phases respectives a, b, c, ainsi que des signaux $I_a$, $I_b$, $I_c$ représentatifs des courants associés à ces phases.

Chaque relais est susceptible de produire, pour chaque phase, un signal représentatif de la composante de tension dans l'un ou chaque système vectoriel équilibré, par exemple :

1) Les composantes de tension de chaque phase a, b, c, dans le système me vectoriel équilibré symétrique direct :

$$V_{da} = 1/3 \ (V_a + r.V_b + r^2.V_c)$$
$$V_{db} = 1/3 \ (V_b + r.V_c + r^2.V_a) = r2.V_{da}$$
$$V_{dc} = 1/3 \ (V_c + r.V_a + r^2.V_b) = r.V_{da}$$

où r est un opérateur de rotation de 120° (souvent noté "a", mais renommé ici "r" pour éviter une confusion avec la phase "a"), représenté par le nombre complexe $r = \exp(\frac{2i}{3} \cdot PI)$ ;

2) Les composantes de tension de chaque phase, a, b, c, dans le système vectoriel équilibré symétrique inverse :

$$V_{ia} = 1/3 \ (V_a + r^2.V_b + r.V_c)$$
$$V_{ib} = 1/3 \ (V_b + r^2.V_c + r.V_a) = r.V_{ia}$$
$$V_{ic} = 1/3 \ (V_c + r^2.V_a + r.V_b) = r^2.V_{ia}$$

3) Les composantes de tension de chaque phase a, b, c, dans le système vectoriel équilibré homopolaire, qui sont toutes égales entre elles et notées $V_o$ avec :

$$V_o = 1/3 \ (V_a + V_b + V_c).$$

L'enseignement de l'invention est qu'il convient de prendre en considération plus d'un paramètre électrique, tel que la tension ou le courant.

Ainsi, le relais doit non seulement être susceptible de produire, pour chaque phase, un signal représentatif d'une composante de tension dans un système me vectoriel équilibré, mais il doit aussi être susceptible de produire, pour chaque phase, un signal représentatif de la composante de courant dans l'un ou chaque système vectoriel équilibré, par exemple :

1) Les composantes de courant de chaque phase a, b, c, dans le système vectoriel équilibré symétrique direct, notées $I_{da}$, $I_{db}$ et $I_{dc}$ et répondant à des définitions homologues de celles des composantes $V_{da}$, $V_{db}$ et $V_{dc}$ ;

2) Les composantes de courant de chaque phase a, b, c, dans le système vectoriel équilibré symétrique inverse, notées $I_{ia}$, $I_{ib}$ et $I_{ic}$ et répondant à des définitions homologues de celles des composantes $V_{ia}$, $V_{ib}$, et $V_{ic}$ ;

3) et les composantes de courant de chaque phase dans le système vectoriel équilibré homopolaire, qui sont toutes égales entre elles et notées $I_o$, avec :

$$I_o = 1/3 \ (I_a + I_b + I_c).$$

L'invention repose sur l'utilisation de signaux S représentés par des combinaisons linéaires de composantes de tension et de courant, par exemple de signaux tels que $K_1 \cdot V_{ia} + K_2 \cdot I_{ia}$ où $K_1$ et $K_2$ sont des grandeurs réelles ou complexes constantes.

Dans une forme de réalisation particulière, l'invention fait usage de signaux S tels que :

$$S_{da} = V_{da} - Z_{dk}.I_{da}$$
$$S_{db} = V_{db} - Z_{dk}.I_{db}$$
$$S_{dc} = V_{dc} - Z_{dk}.I_{dc}$$
$$S_{ia} = V_{ia} - Z_{ik}.I_{ia}$$
$$S_{ib} = V_{ib} - Z_{ik}.I_{ib}$$
$$S_{ic} = V_{ic} - Z_{ik}.I_{ic}$$
$$S_o = V_o - Z_{dk}.I_o$$

où $Z_{dk}$, $Z_{ik}$ et $Z_{ok}$ sont des coefficients de pondération choisis, et de préférence ajustables, en fonction de la configuration du réseau protégé.

L'invention a fait apparaître que ces signaux composites S étaient susceptibles d'être utilisés comme les composantes de tension V ou de courant I étaient séparément utilisées conformément à l'enseignement du brevet FR 1597420.

La selection de conducteurs en défaut est donc obtenue, selon l'invention, en comparant les angles de phase d'au moins deux signaux S tels que $S_{ia}$ et $S_o$, ou $S_{ia}$ et $S_{da}$ pour la phase a.

Plus précisément, dans le cas de défauts dissymétriques à la terre, c'est-à-dire d'un défaut d'isolation d'une ou de deux phases par rapport à la terre (aN, bcN, bN, acN, cN, ou abN), la comparaison, pour toute phase p (p = a, b, ou c) des angles de phase respectifs des signaux $S_{ip}$ et $S_o$ permet de savoir si cette phase p joue, ou non, un rôle privilégié par rapport au défaut.

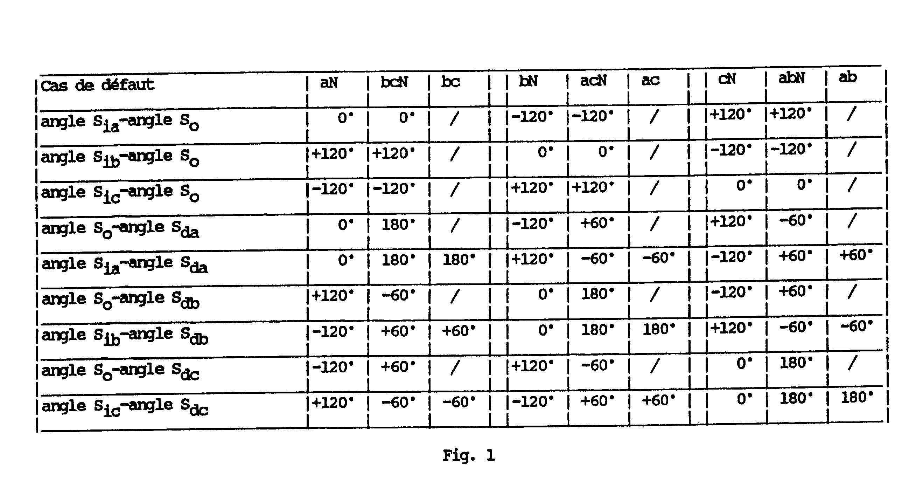

Par exemple, comme le montre la figure 1, la différence, notée Dphi, des angles de phase des composantes $S_{ip}$ et $S_o$ pour une phase p qui est seule en défaut à la terre (défaut aN, bN, ou cN) est idéalement égale à zéro.

De même, la différence Dphi des angles de phase des composantes $S_{ip}$ et $S_o$ pour une phase p qui est seule à ne pas être en défaut (défaut bcN, acN ou abN) est également nulle.

Cette différence est par contre égale à $\pm 120°$ dans les autres cas de défaut.

En conséquence si la différence des angles de phase des composantes $S_{ip}$ et $S_o$ d'une phase p est voisine de zéro (par exemple supérieure à $-60°$ et inférieure à $60°$), la phase p est soit seule en défaut à la terre, soit seule à ne pas être en défaut à la terre.

Pour discriminer entre ces deux dernier cas, il suffit, comme le montre le tableau 1, d'observer la différence des angles de phase des composantes $S_{ip}$ et $S_{dp}$, cette différence étant idéalement nulle (donc sensiblement inférieure à $90°$ par exemple) lorsque la phase p est seule en défaut à la terre, et égale à $180°$ (donc sensiblement supérieure à $90°$ par exemple) lorsque la phase p est la seule à ne pas être en défaut.

Dans le cas de défauts entre phases avec isolation par rapport à la terre, la différence Dphi des angles de phase des composantes $S_{ip}$ et $S_{dp}$ n'est, comme le montre la figure 1, égale à $180°$ (et en tout cas supérieure à $90°$) que pour la phase p qui n'est pas en défaut.

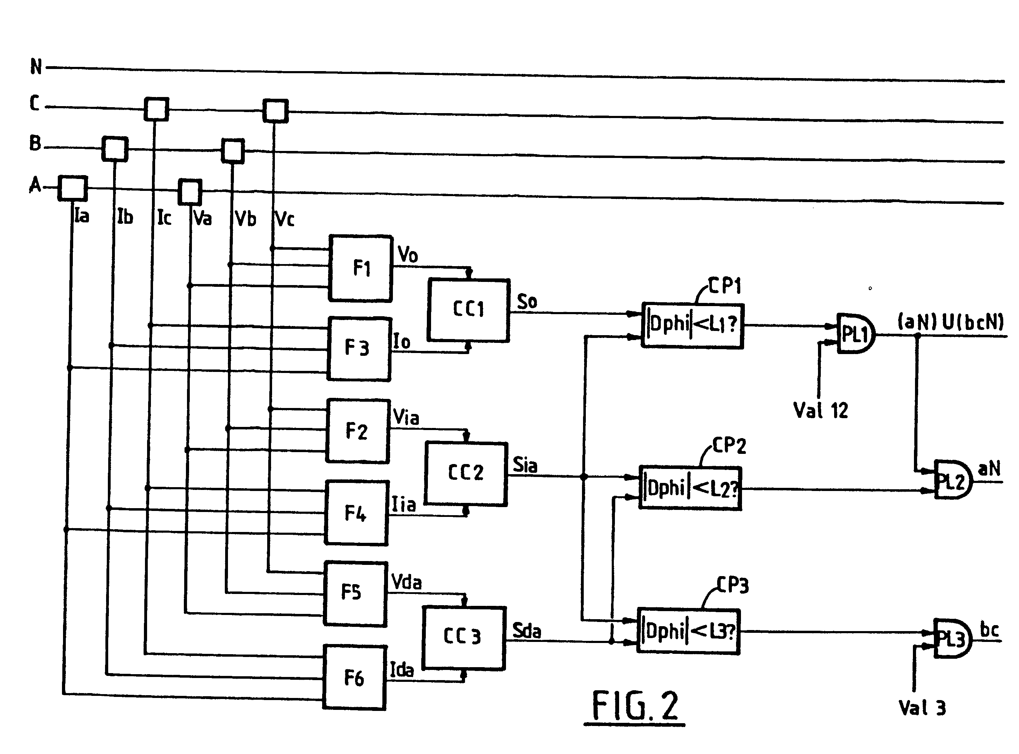

Un dispositif utilisable pour la mise en oeuvre de l'invention est partiellement représenté sur la figure 2, qui fait apparaître la partie de ce dispositif qui est consacrée au traitement de la phase a ; une représentation complète du dispositif ferait donc apparaître deux autres partie semblables, associées aux phases b et c.

Ce dispositif comprend au moins un premier et un second générateurs de fonction $F_1$ et $F_2$, propres à délivrer, à partir des tensions $V_a$, $V_b$ et $V_c$, des premier et second signaux intermédiaires, par exemple $V_o$ et $V_{ia}$.

Les sorties des générateurs de fonction $F_1$ et $F_2$ sont reliées à au moins un premier comparateur d'angles de phase CP1, dont la sortie est reliée à une porte logique ET PL1.

Selon l'invention, le dispositif comprend au moins un troisième et un quatrième générateurs de fonction $F_3$ et $F_4$ propres à délivrer, à partir des courants $I_a$, $I_b$ et $I_c$, des troisième et quatrième signaux intermédiaires $I_o$ et $I_{ia}$.

Un premier circuit de combinaison linéaire CC1 combine les premier et troisième signaux intermédiaires $V_o$ et $I_o$ pour former le signal $S_o = V_o - Z_{ok}.I_o$ et un second circuit de combinaison linéaire CC2 combine les second et quatrième signaux intermédiaires $V_{ia}$ et $I_{ia}$ pour former le signal $S_{ia} = V_{ia} - Z_{ik}.I_{ia}$.

Les sorties des circuits de combinaison linéaire CC1 et CC2 sont connectées aux entrées du comparateur d'angles de phase CP1.

En fait, le dispositif de l'invention comprend aussi de préférence des cinquième et sixième circuits générateurs $F_5$ et $F_6$ fournissant, à partir respectivement des tensions $V_a$, $V_b$ et $V_c$, et des courants $I_a$, $I_b$, et $I_c$, les signaux $V_{da}$ et $I_{da}$, et un troisième circuit de combinaison linéaire CC3 recevant ces signaux $V_{da}$ et $I_{da}$ et fournissant le signal composite $S_{da}$.

Le dispositif comprend aussi deux autres comparateurs d'angles de phase CP2 et CP3 dont les entrées sont reliées aux sorties des circuits CC2 et CC3.

Le comparateur d'angles de phase CP1 délivre à sa sortie un signal logique au niveau "1" si la valeur absolue |Dphi| de la différence des angles de phase des signaux $S_o$ et $S_{ia}$ est inférieure à une première limite L1, par exemple choisie comme étant égale à $60°$.

Le signal de sortie de CP1 est acheminé vers la porte ET PL1 dont une autre entrée reçoit un signal Val12, élaboré par ailleurs par des moyens connus, et dont le niveau "1" indique la présence d'un défaut dissymétrique avec liaison à la terre.

Un état de sortie au niveau "1" de la porte PL1 indique donc que la phase a joue un rôle privilégié dans le défaut, ce dernier ne pouvant alors concerner que aN ou bcN.

Le comparateur d'angles de phase CP2 délivre à sa sortie un signal logique au niveau "1" si la valeur absolue |Dphi| de la différence des angles de phase des signaux $S_{ia}$ et $S_{da}$ est inférieure à une seconde limite L2, par exemple choisie comme étant égale à $90°$.

Le signal de sortie de CP2 est acheminé vers la porte ET PL2, dont une autre entrée reçoit le signal de sortie de la porte ET PL1.

Un état de sortie au niveau "1" de la porte PL2 indique donc un défaut aN, tandis qu'un état au niveau "0" indique un défaut bcN.

Le comparateur d'angles de phase CP3 délivre à sa sortie un signal logique au niveau "1" si la valeur absolue |Dphi| de la différence des angles de phase des signaux $S_{ia}$ et $S_{da}$ est supérieure à une troisième limite L3, par exemple choisie comme étant égale à $90°$.

Le signal de sortie de ce comparateur CP3 est acheminé vers la porte logique ET PL3 dont une autre entrée reçoit un signal Val3 élaboré par ailleurs par des moyens connus, et dont le niveau "1" indique la présence d'un défaut dissymétrique isolé par rapport à la terre.

Un état de sortie au niveau "1" de la porte PL3 indique donc un défaut bc.

## Revendications

1. Procédé de recherche en vue de l'identification d'un ou plusieurs conducteurs en défaut dans un élément de transport d'énergie électrique comprenant trois conducteurs et trois phases (A, B, C) correspondantes, affecté par un défaut dissymétrique, comprenant les opérations consistant à :

— élaborer, au moins à partir des valeurs prises par un paramètre électrique pour les trois phases (A, B, C), un premier signal (Sia) relatif à l'une des phases (par exemple A) et lié à la composante de ce paramètre électrique (V, I) dans un système vectoriel équilibré symétrique inverse,

— élaborer, au moins à partir des valeurs prises par le paramètre électrique (V, I) pour les trois phases (A, B, C), un second signal (So, Sda) relatif à ladite phase (A) et lié à la composante de ce paramètre électrique dans un système vectoriel équilibré non symétrique inverse,

— soumettre les premier et second signaux (Sia; So, Sda) à une comparaison d'angles de phase, et

— déterminer, en fonction du résultat de cette première comparaison, si ladite phase (A) joue, ou non, un rôle privilégié vis-à-vis du défaut, caractérisé en ce que le premier signal (Sia) est une combinaison linéaire des composantes symétriques inverses de tension (Via) et de courant (Iia) relatives à cette phase, et en ce que le second signal (So, Sda) est une combinaison linéaire de composantes de tension(Vo, Vd) et de courant (Io, Id) relatives à cette phase (A) dans un système vectoriel équilibré non symétrique inverse.

2. Procédé suivant la revendication 1 utilisable dans le cas de défauts à la terre, caractérisé en ce que le second signal (So) est une combinaison linéaire des composantes homopolaires de tension (Vo) et de courant (Io) de ladite phase (A).

3. Procédé suivant la revendication 1, utilisable dans le cas de défauts isolés par rapport à la terre, caractérisé en ce que le second signal (Sda) est une combinaison linéaire des composantes directes de tension (Vda) et de courant (Ida) de ladite phase (A).

4. Procédé suivant la revendication 2, caractérisé en ce qu'il comprend en outre les opérations consistant à :

— élaborer, pour ladite phase (A), un troisième signal (Sda) constitué par une combinaison linéaire des composantes directes de tension (Vda) et de courant (Ida) de cette phase (A),

— soumettre aussi les premier et troisième signaux (Sia, Sda) à une comparaison d'angles de phases, et

— déterminer, en fonction du résultat de cette seconde comparaison, si le défaut affecte un ou deux conducteurs.

5. Procédé suivant l'une quelconque des revendications précédentes, caractérisé en ce que chaque combinaison linéaire adopte la forme $V - Z_k \cdot I$, où V est la composante de tension, I la composante de courant et $Z_k$ un coefficient de pondération.

6. Dispositif pour l'identification, dans un élément de transport d'énergie électrique à trois conducteurs et trois phases (A, B, C) correspondantes affecté par un défaut dissymétrique, de la phase qui, vis-à-vis du défaut, joue un rôle privilégié, comprenant :

— des premier ($F_1$) et second ($F_2$) moyens pour produire, au moins à partir des valeurs prises par un premier paramètre électrique représentatif des tensions (V) pour les trois phases (A, B, C), des premier (Vo) et second (Via) signaux intermédiaires relatifs à l'une des phases (par exemple A) et liés respectivement à la composante de ce paramètre électrique dans un système vectoriel équilibré non symétrique inverse et symétrique inverse,

— un comparateur d'angles de phase ($CP_1$, $CP_2$, $CP_3$), et

— un circuit logique ($PL_1$, $PL_2$, $PL_3$) relié à la sortie de ce comparateur, caractérisé en ce qu'il comprend en outre :

— des troisième ($F_3$) et quatrième ($F_4$) moyens pour produire, à partir des valeurs prises par un second paramètre électrique représentatif des courants (I) pour les trois phases (A, B, C), des troisième (Io) et quatrième (Iia) signaux relatifs à ladite phase (A), et liés respectivement à la composante de ce paramètre électrique dans un système vectoriel équilibré non symétrique inverse et symétrique inverse

— un premier circuit de combinaison linéaire (CC1) pour élaborer un premier signal de sortie (So) représentant une combinaison linéaire des premier et troisième signaux intermédiaires (Vo, Io), et

— un second circuit de combinaison linéaire (CC2) pour élaborer un deuxième signal de sortie (Sda) représentant une combinaison linéaire des second et quatrième signaux intermédiaires (Via, Iia), ledit comparateur d'angles de phase (CP1) recevant les signaux de sortie (Sia, So) des premier et second circuits de combinaison linéaire (CC1, CC2).

## Patentansprüche

1. Suchverfahren zur Identifizierung eines oder mehrerer fehlerbehafteter Leiter in einem elektrischen Energieübertragungssystem mit drei Leitern und drei entsprechenden Phasen (A, B, C), die von einem Asymmetriefehler betroffen sind, wobei das Verfahren folgende Schritte aufweist :

— mindestens aus den Werten, welche von einem elektrischen Parameter für die drei Phasen (A, B, C) angenommen werden, wird ein erstes Signal ($S_{ia}$) bezüglich einer der Phasen (z.B. A) erzeugt, das an die Komponenten dieses Parameters (V, I) in einem inversen, symmetrischen, äquilibrierten Vektorsystem gebunden ist,

— mindestens aus den Werten, welche vom dem elektrischen Parameter (V, I) für die drei Phasen (A, B, C) angenommen werden, wird ein zweites Signal ($S_o$, $S_{da}$) bezüglich dieser Phase (A) erzeugt, das an die Komponente dieses elektrischen Parameters in einem inversen, unsymmetrischen, äquilibrierten Vektorsystem gebunden ist,

— die ersten und zweiten Signale ($S_{la}$ ; $S_o$, $S_{da}$) werden einem Phasenwinkelvergleich unterzogen, und

— in Abhängigkeit vom Ergebnis dieses ersten Vergleichs wird entschieden, ob die Phase (A) eine bevorzugte Rolle in Bezug auf den Fehler spielt oder nicht, dadurch gekennzeichnet, daß das erste Signal ($S_{la}$) eine lineare Kombination der inversen, symmetrischen Spannungs- und Stromkomponenten ($V_{la}$ bzw. $I_{la}$) der betreffenden Phase ist, und daß das zweite Signal ($S_o$, $S_{da}$) eine lineare Kombination der Spannungs- und Stromkomponenten ($V_o$, $V_d$ bzw. $I_o$, $I_d$) der betreffenden Phase (A) in einem inversen, unsymmetrischen, äquilibrierten Vektorsystem ist.

2. Verfahren nach Anspruch 1, zur Verwendung bei Erdschlußfehlern, dadurch gekennzeichnet, daß das zweite Signal ($S_o$) eine lineare Kombination der gleichpoligen Spannungs- und Stromkomponenten ($V_o$ bzw. $I_o$) der betreffenden Phase (A) ist.

3. Verfahren nach Anspruch 1 zur Verwendung bei gegen Erde isolierten Fehlern, dadurch gekennzeichnet, daß das zweite Signal ($S_{da}$) eine lineare Kombination der direkten Spannungs- und Stromkomponenten ($V_{da}$ bzw. $I_{da}$) der betreffenden Phase (A) ist.

4. Verfahren nach Anspruch 2, dadurch gekennzeichnet, daß es weiter die folgenden Schritte aufweist :

— für die ausgewählte Phase (A) wird ein drittes Signal ($S_{da}$) erzeugt, das aus einer linearen Kombination der direkten Spannungs- und Stromkomponenten ($V_{da}$ bzw. $I_{da}$) der betreffenden Phase (A) besteht,

— die ersten und dritten Signal ($S_{la}$, $S_{da}$) werden ebenfalls einem Phasenwinkelvergleich unterzogen, und

— in Abhängigkeit vom Ergebnis dieses zweiten Vergleichs wird entschieden, ob der Fehler einen oder zwei Leiter betrifft.

5. Verfahren nach einem beliebigen der vorhergehenden Ansprüche, dadurch gekennzeichnet, daß jede Linearkombination die Form $V-Z_k.I$ besitzt, wobei V die Spannungskomponente, I die Stromkomponente und $Z_k$ ein Gewichtungskoeffizient ist.

6. Einrichtung zur Identifizierung derjenigen Phase innerhalb eines von einem umsymmetrischen Fehler betroffenen elektrischen Energieübertragungssystems mit drei Leitern und drei entsprechenden Phasen (A, B, C), die in Bezug auf den Fehler eine bevorzugte Rolle spielt,

— mit ersten ($F_1$) und zweiten Mitteln ($F_2$) zur Erzeugung erster ($V_o$) und zweiter Zwischensignale ($V_{la}$) bezüglich einer der Phasen (z.B. A) zumindest aus Werten, die von einem ersten elektrischen Parameter, welcher für die Spannungen (V) der drei Phasen (A, B, C) repräsentativ ist, angenommen werden, wobei diese Signale an die Komponente dieses elektrischen Parameters in einem inversen unsymmetrischen bzw. in einem inversen symmetrischen äquilibrierten Vektorsystem gebunden sind,

— mit einem Phasenwinkelkomparator ($CP_1$, $CP_2$, $CP_3$), und

— mit einem Logikkreise ($PL_1$, $PL_2$, $PL_3$), der an den Ausgang des Komparators angeschlossen ist, dadurch gekennzeichnet, daß die Einrichtung weiter aufweist :

— dritte ($F_3$) und vierte Mittel ($F_4$) zur Erzeugung dritter ($I_o$) und vierter Signale ($I_{la}$) bezüglich dieser Phase (A) aus den von einem zweiten elektrischen Parameter, welcher für die Ströme (I) der drei Phasen (A, B, C) repräsentativ ist, angenommenen Werten, wobei diese Signale an die Komponente dieses elektrischen Parameters in einem inversen unsymmetrischen bzw. in einem inversen symmetrischen äquilibrierten Vektorsystem gebunden sind,

— einen ersten Linearkombinationskreis (CC1) zur Erzeugung eines ersten Ausgangssignals ($S_o$), das eine lineare Kombination der ersten und dritten Zwischensignale ($V_o$, $I_o$) darstellt, und

— einen zweiten Linearkombinationskreis (CC2) zur Erzeugung eines zweiten Ausgangssignals ($S_{da}$), das eine lineare Kombination der zweiten und vierten Zwischensignale ($V_a$, $I_a$) darstellt, wobei der Phasenwinkelkomparator ($CP_1$) die Ausgangssignale ($S_{la}$, $S_o$) der ersten und zweiten Linearkombinationskreise (CC1, CC2) empfängt.

## Claims

1. A method of searching for identification purposes for one or more fault conductors in a portion of electrical energy transport means including three conductors and three corresponding phases (A, B, C), suffering from an asymmetrical fault, the method comprising the following operations :

generating a first signal (Sia) concerning one of the phases (e. g. A) at least on the basis of values taken beyond electrical parameter for the three phases (A, B, C), the first signal being related to the component of said electrical parameter (V, I) in an inverse symmetrical balance vector system;

generating a second signal (So, Sda) concerning said one of the phases (A) at least on the basis of values taken by the electrical parameters (V, I) for the three phases (A, B, C), the second signal being related to the component of said electrical parameter in an inverse non-symmetrical balanced vector system ;

subjecting the first and second signals (Sia, So, Sda) to a first phase angle comparison ; and

determining as a function f said first comparison whether or not said phase (A) plays a privileged role relative to the fault, characterized in that the first signal (Sia) is a linear combination of the symmetrical inverse components of voltage (Via) and of current (Iia) concerning said phase, and in that the second signal (So, Sda) is a linear combination of the inverse non-symmetrical components of voltage (Vo, Vd) and of current (Io, Id) concerning said phase (A) in a non-symmetrical inverse balanced vector system.

2. A method according to claim 1, usable with ground faults, characterized in that the second signal (So) is a linear combination of homopolar components of voltage (Vo) and of current (Io) of said phase (A).

3. A method according to claim 1, usable with faults that are isolated relative to ground, characterized in that the second signal (Sda) is a linear combination of direct components of voltage (Vda) and of current (Ida) of said phase (A).

4. A method according to claim 2, characterized in that it further includes the following operations :

generating a third signal (Sda) for said phase (A), said third signal being constituted by a linear combination of direct components of voltage (Vda) and of current (Ida) of said phase (A) ;

subjecting the first and third signals (Sia, Sda) to a second phase angle comparison ; and

determining, as a function of the result of said second comparison, whether the fault affects one or two conductors.

5. A method according to any preceding claim, characterized in that each of the liner combinations has the form V-Zk.I, where V is the voltage component, I is the current component, and Zk is a weighting coefficient.

6. Apparatus for identifying that phase in a portion of electrical energy transport means including three conductors and three corresponding phases suffering from an asymmetrical fault which plays a privileged role relative to the fault, the apparatus comprising :

first and second means (F1, F2) for producing first and second intermediate signals (Vo, Via) concerning one of the phases (e.g. A) at least on the basis of values taken by a first electrical parameter representative of voltage (3) for the three phases (A, B, C), the first and second intermediate signals relating respectively to the component of said electrical parameter in an inverse non-symmetrical balanced vector system and in an inverse symmetrical balanced vector system ;

a phase angle comparator (CP1, CP2, CP3) ; and a logic circuit (PL1, PL2, PL3) connected to the output of said comparator, the apparatus being characterized in that it further comprises :

third and fourth means (F3, F4) for producing third and fourth intermediate signals (Io, Iia) concerning said phase (A) at least on the basis of values taken by a second electrical parameter representative of current (I) in the three phases (A, B, C), the third and fourth intermediate signals relating respectively to the component of said electrical parameter in an inverse non-symmetrical balanced vector system and in an inverse symmetrical balanced vector system ;

a first linear combination circuit (CC1) or generating a first output signal (So) representing a linear combination of the first and third intermediate signals (Vo, Io) ; and

a second linear combination circuit (CC2) for generating a second output signal (Sda) representing a linear combination of the second and fourth intermediate signals (Via, Iia), said phase angle comparator (CP1) receiving the output signals (Sia, So) from the first and second linear combination circuits (CC1, CC2).

| Cas de défaut | aN | bcN | bc | bN | acN | ac | cN | abN | ab |
|---|---|---|---|---|---|---|---|---|---|
| angle $S_{ia}$-angle $S_o$ | 0° | 0° | / | -120° | -120° | / | +120° | +120° | / |
| angle $S_{ib}$-angle $S_o$ | +120° | +120° | / | 0° | 0° | / | -120° | -120° | / |
| angle $S_{ic}$-angle $S_o$ | -120° | -120° | / | +120° | +120° | / | 0° | 0° | / |
| angle $S_o$-angle $S_{da}$ | 0° | 180° | / | -120° | +60° | / | +120° | -60° | / |
| angle $S_{ia}$-angle $S_{da}$ | 0° | 180° | 180° | +120° | -60° | -60° | -120° | +60° | +60° |
| angle $S_o$-angle $S_{db}$ | +120° | -60° | / | 0° | 180° | / | -120° | +60° | / |
| angle $S_{ib}$-angle $S_{db}$ | -120° | +60° | +60° | 0° | 180° | 180° | +120° | -60° | -60° |
| angle $S_o$-angle $S_{dc}$ | -120° | +60° | / | +120° | -60° | / | 0° | 180° | / |
| angle $S_{ic}$-angle $S_{dc}$ | +120° | -60° | -60° | -120° | +60° | +60° | 0° | 180° | 180° |

Fig. 1

FIG. 2